(19) Europäisches Patentamt / European Patent Office / Office européen des brevets

(11) **EP 3 182 705 B1**

(12) **EUROPEAN PATENT SPECIFICATION**

(45) Date of publication and mention
of the grant of the patent:
**17.11.2021 Bulletin 2021/46**

(21) Application number: **16202900.3**

(22) Date of filing: **08.12.2016**

(51) Int Cl.:
*H03M 7/40* (2006.01)     *H03M 7/42* (2006.01)
*H04N 19/13* (2014.01)     *H04N 19/91* (2014.01)
*H04N 19/96* (2014.01)     *H04N 19/70* (2014.01)

(54) **BINARIZER SELECTION FOR IMAGE AND VIDEO CODING**

BINARISIERERAUSWAHL ZUR BILD- UND VIDEOCODIERUNG

SÉLECTION DE DISPOSITIF DE BINARISATION POUR LE CODAGE D'IMAGE ET DE VIDÉO

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **18.12.2015 US 201514974651**

(43) Date of publication of application:
**21.06.2017 Bulletin 2017/25**

(73) Proprietor: **BlackBerry Limited
Waterloo, ON N2K 0A7 (CA)**

(72) Inventor: **HE, Dake
Waterloo, Ontario N2K 0A7 (CA)**

(74) Representative: **MERH-IP Matias Erny Reichl
Hoffmann
Patentanwälte PartG mbB
Paul-Heyse-Strasse 29
80336 München (DE)**

(56) References cited:
**EP-A1- 2 557 792**     **WO-A1-2011/125314**
**US-A1- 2005 012 647**

• **SALOMON D ED - SALOMON DAVID: "DATA
COMPRESSION THE COMPLETE REFERENCE,
PASSAGE", 1 January 1998 (1998-01-01), DATA
COMPRESSION : THE COMPLETE REFERENCE,
SPRINGER, NEW YORK, PAGE(S) A, 38 - 40, 50,
XP001149673, ISBN: 978-0-387-98280-9**

**Description**

**FIELD**

The present application generally relates to data compression and, in particular, to methods and devices for binarizer selection in image and video coding.

**BACKGROUND**

Data compression is used in communications and computer networking to store, transmit, and reproduce information efficiently. It finds particular application in the encoding of images, audio and video. Common image compression formats include JPEG, TIFF, and PNG. A newly-developed video coding standard is the ITU-T H.265/HEVC standard. Other video coding formats include the VP8 and VP9 formats developed by Google Inc. Evolutions to all of these standards and formats are under active development.

All of these image and video coding standards and formats are based on predictive coding that create a prediction of data to be coded, then encode the error in the prediction (often called the residual) for transmission to a decoder as a bitstream. The decoder then makes the same prediction and adjusts it by the reconstructed error decoded from the bitstream. The lossless data compression of the error at the encoder often includes a spectral transform of the error to create blocks of transform domain coefficients. This is typically accompanied by lossy quantization. The reverse operations are performed at the decoder to reconstruct the error/residual. In many coding schemes, this data, plus side information for making the predictions (e.g. intra-coding mode or inter-coding motion vectors) is usually encoded using binary arithmetic coding (BAC). This means that the non-binary portions of the data (termed "symbols" herein) may need to be binarized to create a stream of binary data for the BAC engine to encode. In some encoders/decoders, multi-level arithmetic coders may be used instead of binary arithmetic coders, in which case the binarizer is embedded within the multi-level arithmetic coder.

In existing coding schemes, the binarizer is prescribed by the standard. For example, in H.265/HEVC, the binarization scheme (CABAC) is very closely integrated with the context modeling. In VP8/VP9, the binarization of "tokens" (symbols that signal the magnitude of quantized coefficients) is carried out using a pre-defined coding tree.

EP 2 557 792 A1 relates to video encoding devices and video decoding devices. An encoding controlling unit selects one transformation block size which provides an optimal degree of encoding efficiency from a set of transformation block sizes which are determined in accordance with an encoding mode, and includes the transformation block size selected thereby in optimal compression parameters to notify the transformation block size to a transformation/quantization unit, and the transformation/quantization unit divides an optimal prediction differential signal into blocks having the transformation block size included in the optimal compression parameters, and carries out a transformation and quantization process on each of the blocks to generate compressed data. In one implementation, a variable length encoding unit includes a binarization table memory that stores a binarization table for converting symbols to sequences of bins. A frequency information generating unit keeps track of the frequency of occurrence of possibly symbol values and generates frequency information. In the event of a binarization table update flag being raised, a binarization table updating unit refers to the frequency information for updating the binarization table. The binarization table update flag may be raised if the frequency information has changed by a certain amount since the last update of the binarization table. The actual updating of the binarization table is performed based on the frequency information, by swapping leaf nodes in the binarization tree corresponding to the binarization table.

**BRIEF DESCRIPTION OF THE DRAWINGS**

Reference will now be made, by way of example, to the accompanying drawings which show example embodiments of the present application, and in which:

Figure 1A shows, in simplified block diagram form, an encoder for encoding video using a binarizer and a binary arithmetic encoder;

Figure 1B shows, in simplified block diagram form, an example encoder with a binarizer selector and a binary arithmetic encoder;

Figure 2A shows, in simplified block diagram form, a decoder for decoding video using an inverse binarizer and a binary arithmetic decoder;

Figure 2B shows, in simplified block diagram form, an example decoder with a binarizer selector and a binary arithmetic decoder;

Figure 3A shows, in simplified block diagram form, an encoder for encoding video using a binarizer and a multi-level arithmetic encoder;

Figure 3B shows, in simplified block diagram form, an example encoder with a binarizer selector and a multi-level arithmetic encoder;

Figure 4A shows, in simplified block diagram form, a decoder for decoding video using an inverse binarizer and a multi-level arithmetic decoder;

Figure 4B shows, in simplified block diagram form, an example decoder with a binarizer selector and a multi-level arithmetic decoder;

Figure 5 diagrammatically shows an example coding tree for tokens in VP8 and VP9;

Figure 6 diagrammatically shows an example of a modified coding tree for tokens;

Figure 7 shows, in flowchart form, an example process for encoding an image using binarizer selection;

Figure 8 shows, in flowchart form, an example process for decoding a bitstream to reconstruct an image using binarizer selection;

Figure 9 shows a simplified block diagram of an example embodiment of an encoder; and

Figure 10 shows a simplified block diagram of an example embodiment of a decoder.

Similar reference numerals may have been used in different figures to denote similar components.

## DESCRIPTION OF EXAMPLE EMBODIMENTS

The present invention provides methods and encoders/decoders for encoding and decoding images and/or video, having the features of the respective independent claims. Preferred embodiments are described in the dependent claims.

In a first aspect, the present application describes a method of decoding an image in a video or image decoder from a bitstream, the bitstream having header information for a set of blocks, the decoder having an arithmetic decoder to convert the bitstream into a sequence of bins, the decoder having a default binarizer to transform bins into symbols. The method includes obtaining the header information from the bitstream; determining from the header information that a modified binarizer is to be used, instead of the default binarizer, with respect to a sequence of bins for the set of blocks; and reconstructing a sequence of symbols from the sequence of bins using the modified binarizer to inverse binarize the sequence of bins.

In another aspect, the present application describes a method of encoding an image within an image or video encoder to generate a bitstream of encoded data, the image having a set of blocks, the encoder having an arithmetic encoder to convert bins into the bitstream of encoded data, the encoder having a default binarizer to transform symbols into bins. The method includes determining, for the set of blocks, that a modified binarizer is to be used, instead of the default binarizer, to binarize a sequence of symbols within that set of blocks; binarizing the sequence of symbols using the modified binarizer to generate a sequence of bins; arithmetically encoding the sequence of bins using the arithmetic encoder to generate the bitstream of encoded data; and inserting header information in the bitstream that indicates that the modified binarizer is to be used, instead of the default binarizer, with respect to the sequence of bins.

In a further aspect, the present application describes encoders and decoders configured to implement such methods of encoding and decoding.

In yet a further aspect, the present application describes non-transitory computer-readable media storing computer-executable program instructions which, when executed, configured a processor to perform the described methods of encoding and/or decoding.

Other aspects and features of the present application will be understood by those of ordinary skill in the art from a review of the following description of examples in conjunction with the accompanying figures.

It will be understood that some aspects of the present application are not limited to either image or video coding and may be applied to general data compression in some embodiments.

In the description that follows, some example embodiments are described with reference to the H.264/AVC standard for video coding, the H.265/HEVC standard, the VP8 format, the VP9 format, or others. Those ordinarily skilled in the art will understand that the present application is not limited to those video coding standards and formats but may be applicable to other video coding/decoding standards and formats, including possible future standards, multi-view coding standards, scalable video coding standards, 3D video coding standards, and reconfigurable video coding standards. Similarly, to the extent that reference is made to particular image coding standards and formats, it will be appreciated that the processes and devices described may be implemented in connection with other standards, including future standards

In the description that follows, when referring to video or images the terms frame, picture, slice, tile, quantization group, and rectangular slice group may be used somewhat interchangeably. Those of skill in the art will appreciate that a picture or frame may contain one or more slices or segments. A series of frames/pictures may be called a "sequence" in some cases. Other terms may be used in other video or image coding standards. It will also be appreciated that certain encoding/decoding operations might be performed on a frame-by-frame basis, some are performed on a slice-by-slice basis, some picture-by-picture, some tile-by-tile, and some by rectangular slice group, *etc.*, depending on the particular requirements or terminology of the applicable image or video coding standard. In any particular embodiment, the applicable image or video coding standard may determine whether the operations described below are performed in connection with frames and/or slices and/or pictures and/or tiles and/or rectangular slice groups, *etc.*, as the case may be. Accordingly, those ordinarily skilled in the art will understand, in light of the present disclosure, whether particular operations or processes described herein and particular references to frames, slices, pictures, tiles, rectangular slice groups are applicable to frames, slices, pictures, tiles, rectangular slice groups, or some or all of those for a given embodiment. This also applies to coding tree units, coding units, prediction units, transform units, quantization groups, *etc.*, as will become apparent in light of the description below.

In the description below, example embodiments are described that involve an example binarizer from VP8 and VP9, specifically a coding tree for tokens. It will be appreciated that tokens in VP8 and VP9 are one example of a "symbol", and that the present application is not limited to "tokens". It will also be appreciated that while example implementations of the present application may involve VP8, VP9 or evolutions of that format, it is not limited to such coding schemes. It will also be appreciated that the present application may be applicable to binarizers other than coding trees and other than the specific coding trees described herein.

In the present application, the term "and/or" is intended to cover all possible combinations and sub-combinations of the listed elements, including any one of the listed elements alone, any sub-combination, or all of the elements, and without necessarily excluding additional elements.

In the present application, the phrase "at least one of ...or..." is intended to cover any one or more of the listed elements, including any one of the listed elements alone, any sub-combination, or all of the elements, without necessarily excluding any additional elements, and without necessarily requiring all of the elements.

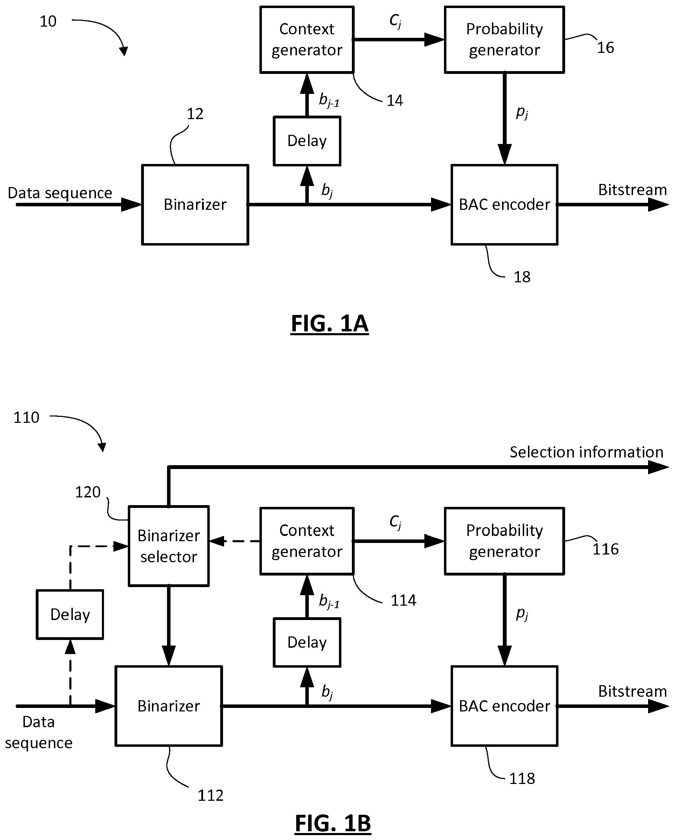

Reference is now made to Figure 1A, which shows, in simplified block diagram form, an encoder 10 for encoding video. This example encoder involves binarization before context modeling. In other words, the context is determined for binarized bins rather than for pre-binarization symbols of an incoming data sequence.

The encoder 10 includes a binarizer 12 that converts an incoming data sequence of symbols (which may include data that has been generated through other coding manipulations, including spectral transforms, quantization, predictive operations, etc.) into a sequence of bins, $b_1, b_2, \cdots b_{j-1}, b_j \cdots$ .

The encoder 10 further includes a context generator 14. In order to encode bin $b_j$ the context generator 14 determines a context $C_j$ from the encoded history, *e.g.*, $b_{j-1}b_{j-2} \cdots$ and available side information (*e.g.* the position of $b_j$ in a transform block). A probability generator 16 then determines $p_j$ from $C_j$ and the encoded history $b_{j-1}b_{j-2} \cdots$, *e.g.* the encoded binary symbols that appear under the same context $C_j$.

A binary arithmetic coding (BAC) encoder 18 encodes $b_j$ based on the determined probability $p_j$ given the context $C_j$ for $b_j$. The BAC encoder 18 outputs a bitstream of arithmetically encoded data. In other words, the BAC encoder 18 relies upon a probability that is specific to a determined context for the bin being encoded. In some embodiments, such as H.265/HEVC for example, the binarization is closely related to the context model. For example, H.265/HEVC prescribes the binarization of quantized transform coefficients into a sign bit, a significant-coefficient flag, a greater-than-one flag, *etc.* Each of these binary syntax elements may have its own defined context model for determining context and, thus, the probability associated with that syntax element for coding by the BAC (which is context-adaptive in the case of H.265/HEVC).

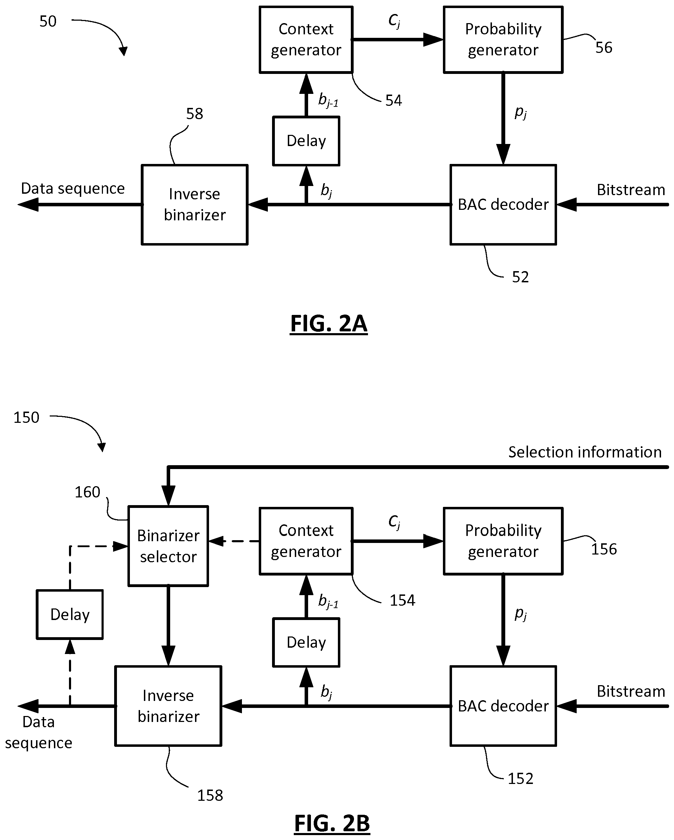

Figure 2A shows, in simplified block diagram form, an example decoder 50 that corresponds to the example encoder 10 of Figure 1A. The example decoder 50 includes a BAC decoder 52. The BAC decoder 52 receives a probability $p_j$ for decoding the bitstream. The probability $p_j$ is provided by a probability generator 56 and is specific to a context $C_j$ specified by a context generator 54. It will be understood that the context modelling, the determination of context, and the probability determinations are the same as carried out in the corresponding encoder 10 so as to enable the decoder 50 to decode the bitstream accurately. An inverse binarizer 58 reconstructs the sequence of symbols based on the decoded sequence of bins output by the BAC decoder 52.

The present application may also be applicable in the case of multi-level arithmetic coding (MAC). This type of coding deals with sequences formed of symbols from an alphabet whose cardinality is greater than 2. In MAC, a binary search tree is used to represent $A$, where each symbol in $A$ corresponds to a unique leaf in the binary search tree. As such, to encode and decode a symbol $a$ in $A$, one encodes and decodes the path consisting of branches from the root to the leaf corresponding to $a$. Note that a convention may be adopted to label the left branch "0" and the right branch "1" or any other convention to label the branches with elements in {0, 1}. Observe that the binary search tree representation of alphabet $A$ is part of MAC. As such, MAC can be used together with context models designed for the original sequence.

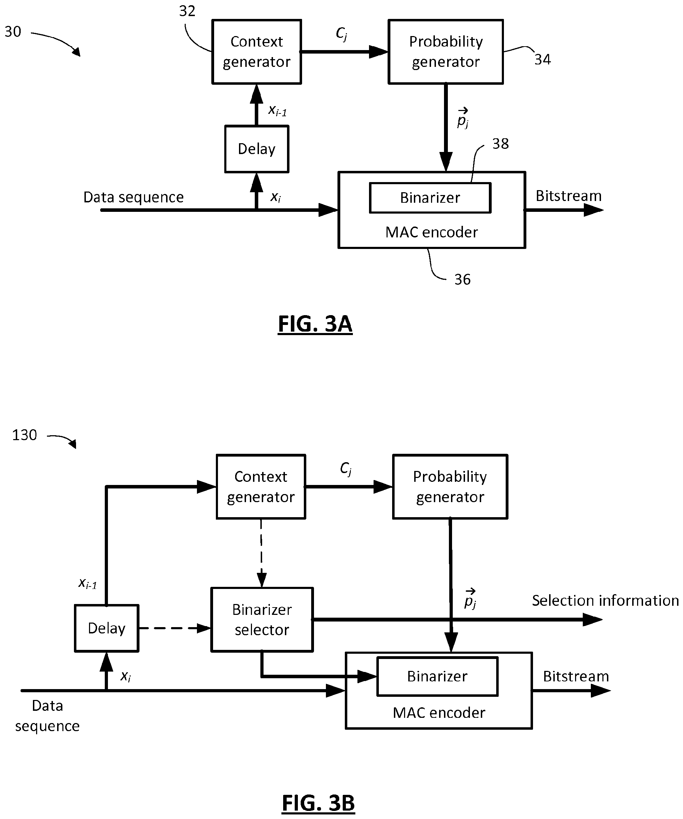

Reference is now made to Figure 3A, which shows, in simplified block diagram form, an encoder 30 for encoding video. The encoder 30 includes a context generator 32 for determining context in accordance with a context model, and a probability generator 34 for determining the probability(ies) associated with a given context. This example encoder 30 involves binarization after context modeling. In other words, the context is determined for pre-binarization symbols of an incoming data sequence, and the sequence is then binarized within a MAC encoder 36, which includes, as a part of it, a binarizer 38. In some embodiments, the binarizer 38 may take the form of a binary search tree for converting a symbol to a binary string given the context determined for the symbol.

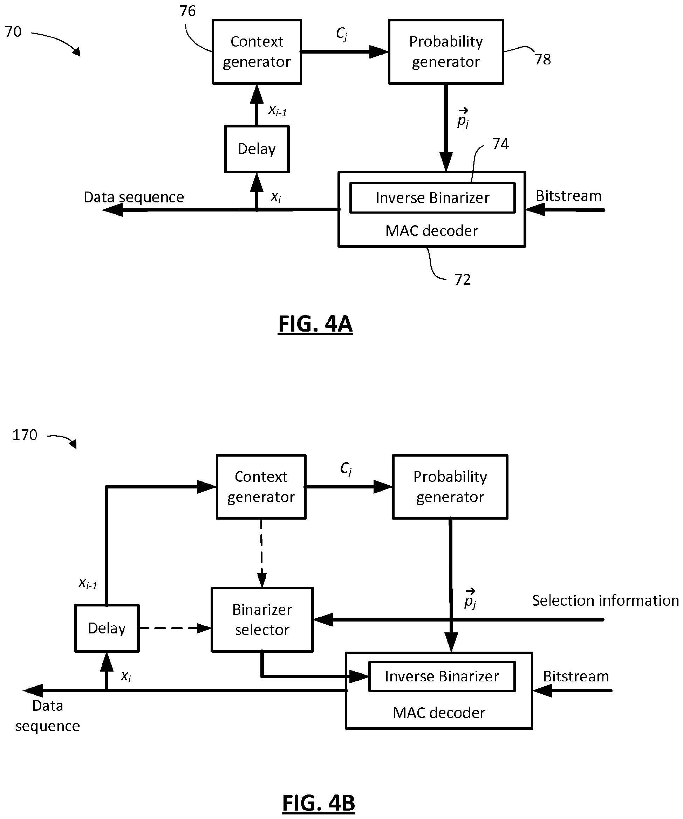

A corresponding simplified block diagram of a decoder 70 is shown in Figure 4A. The decoder 70 includes a MAC decoder 72 with integrated inverse binarizer 74, and receives probability information for decoding the incoming bitstream of encoded data from a context generator 76 and probability generator 78.

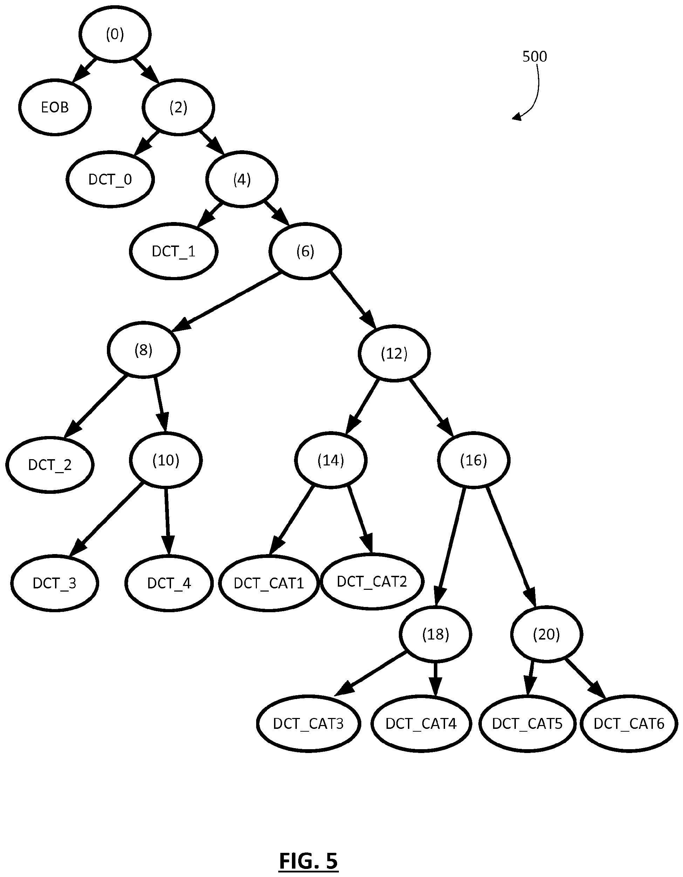

Reference will now be made to Figure 5, which shows an example coefficient coding tree 500. The tree 500 in this example is the coding tree used for encoding a "token" representative of a quantized transform domain coefficient in VP8 and VP9. A token in VP8 and VP9 is a binary string that indicates the magnitude of a quantized transform domain coefficient. It is defined as follows:

```
typedef enum
  {DCT_0, /* value 0 */
      DCT_1, /* 1 */
      DCT_2, /* 2 */
      DCT_3, /* 3 */
      DCT_4, /* 4 */
      dct_cat1, /* range 5 - 6 (size 2) */
      dct_cat2, /* 7 - 10 (4) */
      dct_cat3, /* 11 - 18 (8) */
      dct_cat4, /* 19 - 34 (16) */
      dct_cat5, /* 35 - 66 (32) */
      dct_cat6, /* 67 - 2048 (1982) */
      dct_eob, /* end of block */
      num_dct_tokens /* 12 */
        }
   dct_token;
```

In the above, dct_cat1, ..., dct_cat6 each correspond to a finite set of values. To determine the exact value in the set, additional bits are to be encoded and decoded. For example, after dct_cat1 is decoded, an additional bit is to be decoded to determine whether the value is 5 or 6. Similarly, after dct_cat2 is decoded, two additional bits are to be decoded to determine the value in {7, 8, 9, 10}. For dct_cat3 to dct_cat5, 3, 4, and 5 additional bits are needed, respectively. For dct_cat6, 11 additional bits are needed. Furthermore, for any token other than DCT_0 and dct_eob, a sign bit is to be encoded and decoded.

In order to decode a token using the tree 500, the decoder begins with the root node (0) and follows a path to a leaf node corresponding to the token. Each internal node has an associated binary probability distribution associated with whether the left path or right path is taken. Given that there are 11 internal nodes, this means there are 11 binary distributions.

Context is determined for a token based on plane type, scan position, and nearby coefficients. There are 96 contexts in VP8 and VP9, which means there are 1056 binary probability distributions ($11 \times 96$) since each context has its own set of probability distributions. These probability distributions may be stored in an array defined as:
Prob coeff_probs [4] [8] [3] [num_dct_tokens-1];

The coeff_probs are typically fixed for a frame/picture or segment. They may be signaled by the encoder to the decoder.

The example coding tree 500 of Figure 5 may be expressed as follows:

```
const tree_index coeff_tree [2 * (num_dct_tokens - 1)] =
```

```
{ -dct_eob, 2, /* eob = "0" */
  -DCT_0, 4, /* 0 = "10" */
    -DCT_1, 6, /* 1 = "110" */
     8, 12,
      -DCT_2, 10, /* 2 = "11100" */
       -DCT_3, -DCT_4, /* 3 = "111010", 4 = "111011" */
      14, 16,
       -dct_cat1, -dct_cat2, /* cat1 = "111100",
                                        cat2 = "111101" */
      18, 20,
       -dct_cat3, -dct_cat4, /* cat3 = "1111100",
                                        cat4 = "1111101" */
     -dct_cat5, -dct_cat6 /* cat5 = "1111110",
                                        Cat6 = "1111111" */
  };
```

The internal probability distributions arc used by the binary arithmetic coding engine in the encoder and decoder for the arithmetic coding of the bits of a token (*i.e.* a binarized string). It will be appreciated that the structure of the binarizer is fixed by the tree 500 and only the internal probabilities for a given context are adjusted from time-to-time if needed.

Analysis of the theoretical limits for compression performance of an entropy coding method reveal that, in practical implementations of BAC, the un-normalized compression rate, which is defined as the length of the compressed data sequence in bits, grows linearly with respect to the binary sequence length $n$. Note that the (normalized) compression rate is defined as the ratio of the un-normalized compression rate and the input sequence length, that is, the average number of bits per input symbol. Accordingly, one of the possible approaches to improving compression efficiency is to improve the quality or efficacy of the binarization, so as to reduce the binary sequence length $n$. As mentioned above, in existing coding standards, like context-adaptive BAC (CABAC) in H.265/HEVC and VP8/VP9, the binarizer is baked into the context modelling. In particular, the binarizer is fixed for a given context. The binarization is based on a fixed tree or a fixed syntax definition that prescribes how to break down non-binary data (*e.g.*, quantized coefficients) into a binary string. Any binarization that occurs is tied to the context and the transform coefficient data itself, and not to any available probability information.

The present application proposes to signal to the decoder that a modified binarizer is to be used instead of a default binarizer. The encoder may determine to use the modified binarizer in circumstances in which it expects that the modified binarizer will result in a shorter binary sequence than would otherwise be the case with the default binarizer. This change in binarizers is not necessarily a deterministic function of the context, meaning that within the same context (in different blocks or pictures) the encoder/decoder may use different binarizers depending on the selection made by the encoder.

In some example embodiments, the binarizers are pre-designed and the encoder selects the modified binarizer from between two or more pre-defined binarizers, one of which is the default binarizer. In some other example embodiments, the modified binarizer may be constructed on the fly at the encoder. The decoder may either receive details of the newly-constructed binarizer in the bitstream or it may construct the modified binarizer on its own using the same process as the encoder. In some cases, the encoder signals changes to the default binarizer as the mechanism to construct the modified binarizer.

The change in binarizers may be made on the basis of a block, series of blocks, slice, picture, or any other grouping of image/video data, and may be signaled as header information in a header associated with the grouping.

The determination to use a modified binarizer may be based on a number of factors. For example, it may be based upon the encoded history of the data sequence. It may, in some cases, be based upon historical or estimated probabilities associated with a context. It may, in some cases, involve determining or estimating coding distributions of the quantized transform domain coefficients, and constructing a new coding tree that better matches the determined coding distributions. Other mechanisms will be understood by those ordinarily skilled in the art in light of the following description of example embodiments.

Reference will now be made to Figures 1B and 2B, which show simplified block diagrams of an encoder 110 and decoder 150, respectively, using adaptive binarizer selection.

The encoder 110 includes a context generator 114, probability generator 116 and BAC encoder 118 for generating an encoded bitstream from a binarized sequence. In the encoder 110, a binarizer selector 120 constructs or selects a binarizer 112 (*e.g.* possibly from a finite set of predefined candidate binarizers) for binarizing the incoming data sequence. Information regarding the selection (labelled Selection information) may be combined (e.g. multiplexed) with the encoded bitstream (labelled Bitstream) for storage or transmission. In some embodiments, the Selection information is encoded within a header information field.

The construction/selection by the binarizer selector 120 may be based upon the encoded history of the data sequence. It may depend on probability distributions of particular codes or sequences, whether empirically determined or estimated based on previously-coded data. Context information may be received by the binarizer selector 120 in some embodiments.

The decoder 150 includes a BAC decoder 152, a context generator 154 and a probability generator 156. The incoming (demultiplexed) bitstream of encoded data is decoded by the BAC decoder to recreate a binary sequence. The binary sequence is inverse binarized by an inverse binarizer 158 to reconstruct the sequence of symbols. The inverse binarizer 158 is selected/constructed by a binarizer selector 160, based at least in part upon information in Selection information stream. As noted above, the Selection information may be extracted from header fields of the bitstream of encoded data in some cases. The information may, in some embodiments, include information identifying one of a plurality of predefined binarizers, information specifying the structure of the inverse binarizer 158, information specifying probability distributions from which the decoder 150 constructs a corresponding inverse binarizer 158, or other such information enabling the decoder 150 to select or construct the inverse binarizer 158.

Reference is now also made to Figure 3B and 4B, which show simplified block diagrams of additional examples of an encoder 130 and decoder 170, respectively, using adaptive binarizer selection. These examples also include a binarizer selector and the passing of information regarding the selection/construction of the binarizer from encoder 130 to decoder 170.

In the example embodiments below, the default coding tree shown in Figure 5 is an example default binarizer. Various embodiments detail how a modified binarizer may be selected or constructed, and how the decoder determines which binarizer to use or build.

The structure of the default coding tree in VP8 and VP9 is based upon an expected distribution of the tokens (*i.e.* symbols). The actual distribution of tokens for a given set of blocks may deviate from the assumed distribution. Note that a distribution of tokens (sometime termed the "marginal distribution of tokens" herein) is different from the internal node probabilities specified in the coeff_probs array, which are used by BAC in the form of a collection of binary distributions. The marginal distribution of tokens may be specified by a vector of length 12 where each element corresponds to the probability of a distinct token, and the sum of all the token probabilities is equal to 1. Correspondingly, the empirical distribution of tokens in a set of blocks (*e.g.* slice/picture/frame) is a marginal distribution that may be defined as a vector of length 12 such that each element corresponds to the normalized frequency that a token appears in the set of blocks. Specifically, let $n$ denote the total number of tokens in the picture/frame, and let $f_i$ denote the number of times that token $i$, $0 \leq i < 12$, appears in the picture/frame. Then the $i$th element in the vector is equal to $\frac{f_i}{n}$, and the vector is:

$$\left(\frac{f_0}{n}, \frac{f_1}{n}, \cdots, \frac{f_{11}}{n}\right)$$

For convenience, in the following we may also use the un-normalized frequency vector

$$(f_0, f_1, \cdots, f_{11})$$

which is sometimes referred to as the un-normalized empirical distribution.

Let $l_i^*$ denote the number of bins used to represent token $i$ in the default coefficient coding tree defined in VP8 and VP9:

$$l_i^* = \begin{cases} 1 & if\ i = dct\_eob \\ 2 & if\ i = DCT\_0 \\ 3 & if\ i = DCT\_1 \\ 5 & if\ i = DCT\_2 \\ 6 & if\ i = DCT\_3, DCT\_4 \\ 7 & if\ i = dct\_cat1, \cdots, dct\_cat6 \end{cases}$$

Thus, if the default coefficient tree is used, the total number of bins in the slice/picture/frame to be encoded and decoded is

$$\sum_{i=0}^{11} f_i l_i^*$$

Let $l_i$ denote the number of bins used to represent token $i$ by using a selected binarizer that is different from the default coefficient coding tree. Collectively, $(l_0, l_1, \cdots, l_{11})$ is called the length function of the binarizer. It is easy to see that as long as

$$\sum_{i=0}^{11} f_i l_i < \sum_{i=0}^{11} f_i l_i^*$$

then the selected binarizer reduces the total number of bins, and the saving is given by $\sum_{i=0}^{11} f_i (l_i^* - l_i)$. In order to find a binarizer that satisfies the above inequality, one can perform a search among a set of candidate trees with 12 leaf nodes, that is known both to the encoder and the decoder, *e.g.* defined in the specifications like Golomb codes, Gallager-Voorhis codes, *etc.* An alternative method that determines a binarizer by construction is to build a Huffman coding tree with length function $(l_0, l_1, \cdots, l_{11})$ for the given probability distribution $\left(\frac{f_0}{n}, \frac{f_1}{n}, \cdots, \frac{f_{11}}{n}\right)$ and use that Huffman coding tree as the binarizer.

Note that it is not necessary to explicitly construct a Huffman coding tree. In fact, a binary coding tree satisfies the following condition might be sufficient: for any

$$i \neq j, l_i \leq l_j \text{ if } f_i > f_j$$

Note that Huffman coding trees satisfy the above condition and thus may be included as candidates. Further note that once a new binarizer is signaled, the probability distributions, *i.e.,* coeff_probs, are to be interpreted by using the new binarizer. That is, coeff_prob[a][b][c][i] denotes the binary distribution at internal node i in the new binarizer, where a, b, c are contexts derived from the plane type, coeff positions, and nearby coefficients.

### *Selection from Pre-defined Binarizers*

In one embodiment, both the encoder and decoder have two or more predefined binarizers defined in memory, one of which is a default binarizer. For example, in the case of binarization using a coding tree there may be a default coding tree and one or more alternative coding trees. In some examples, the alternative coding trees may be developed based upon a different marginal distribution of symbols (*e.g.* tokens).

The encoder (specifically, the binarizer selector) may determine for a set of blocks (e.g. a slice, frame, picture, group-of-pictures, etc.) whether to use the default binarizer or one of the alternative binarizers. For example, the encoder may determine or estimate the distribution of tokens for that set of blocks. To actually determine the distribution the encoder may need to use two-pass coding. Alternatively, the encoder may estimate the distribution, perhaps based upon statistics from one or more previous sets of blocks. The binarizer selector at the encoder determines which binarizer to use for coding the blocks and then signals the choice in header information relating to the set of blocks.

In some cases, signaling the binarizer to the decoder may include using a flag or code within the header information. In the case of a single alternative binarizer, the encoder may use a binary flag to indicate whether the default binarizer is being used or not. In the case of multiple alternative binarizers, the encoder may include a code to indicate which of the binarizers is to be used for decoding a set of blocks.

### *Redistribution of leaf nodes*

In one embodiment, the structure of the default binarizer stays the same, but the encoder may signal a redistribution of the tokens, *i.e.* a change to which symbols/tokens are assigned to which leaf nodes. For example, with reference to the VP8 and VP9 coding tree, the encoder may determine that the tokens assigned to particular leaf nodes should be rearranged to improve the efficiency of the binarization for a particular set of blocks. In this case, it may signal the rearrangement to the decoder by specifying the order of the tokens in a header field. The distribution of internal coefficient probabilities (the coeff_prob array) stays the same.

For example, in Figure 5 the leaf node that stores dct_eob and the leaf node that stores DCT_1 might be swapped, *i.e.,* after swapping, the former with a short path to the root stores DCT_1, and the latter with a longer path stores dct_eob. One of the benefits of using the existing tree is a simple design of entropy coding that is also backward compatible with the existing design in VP8 and VP9. Observe that in these cases, BAC decoding logic does not need to be changed in that:

> 1. it can use the existing design to determine whether a leaf node is reached, and

> 2. the probabilities stored in coeff_probs correspond to the same internal nodes in the coefficient coding tree.

The only change to the tree is to the respective tokens stored in the leaf nodes are changed. As such, when use_new_coeff_coding_tree_flag is equal to 1, we may specify the new binarizer by using an array T[num_dct_tokens] where T[$i$], $i$=0, ..., num_dct_tokens-1, specifies the token stored in ($i$+1)-th leaf node (counted from left to right in Figure 5). An example array is as follows:

```
T[num_dct_tokens] = {
        DCT_1, /* 1 */
        DCT_2, /* 2 */
        DCT_0, /* value 0 */
        dct_eob, /* end of block */
        DCT_3, /* 3 */
        DCT_4, /* 4 */
        dct_cat1, /* range 5 - 6 (size 2) */
        dct_cat2, /* 7 - 10 (4) */
        dct_cat3, /* 11 - 18 (8) */
        dct_cat4, /* 19 - 34 (16) */
        dct_cat5, /* 35 - 66 (32) */
        dct_cat6 /* 67 - 2048 (1982) */
            }
```

### New tree structure

Instead of keeping the default shape of the coding tree, the encoder may determine a new tree structure that better fits the actual or estimated marginal token distribution. The encoder may then signal the new structure to the decoder in header information for a set of blocks. As an example, the new coefficient coding tree might be parsed as an array T[2 * (num dct tokens - 1)], where the following convention is applied:

> 1. If T[i] is in {0, -1, -2, ..., - num_dct_tokens }, then T[i] is a leaf node, and —T[i] is the token, i.e., 0 indicates dct_eob, 1 indicates DCT_0, etc.

> 2. If T[i] is an even integer, then T[i] is an internal node, whose left child is at position T[i] and whose right child is at position T[i]+1. Note that if T[i] is even, then by convention T[i] no less than i+1, i.e., children always appear after their parent.

> 3. T[0] is the left child of the root, and T[1] is the right child of the root.

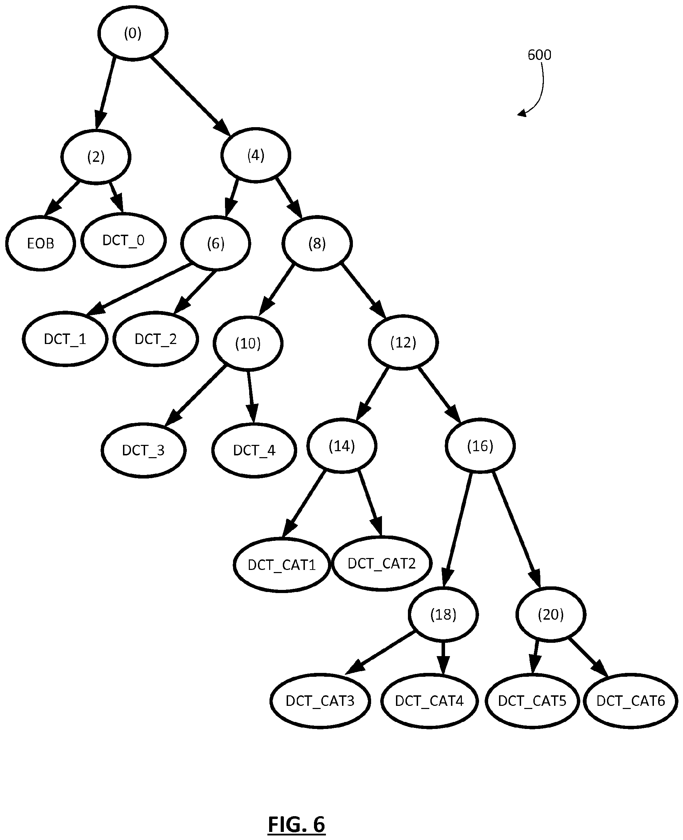

Reference is made to Figure 6, which shows one example of an alternative coding tree 600 for VP8 and VP9 tokens. Below is an example of the array T to define and signal the alternative coding tree 600 shown in Figure 6:

```
T[2*(num_dct_tokens - 1)] =
          {
      2, 4,
      -dct_eob, -DCT_0, /* eob = "00", 0 = "10" */
      6, 8,
      -DCT_1, -DCT_2, /* 1 = "100", 2 = "101" */
      10, 12,
      -DCT_3, -DCT_4, /* 3 = "1100", 4 = "1101" */
```

```
          14, 16,
          -dct_cat1, -dct_cat2, /* cat1 = "11100",
                                       cat2 = "11101" */
          18, 20,
          -dct_cat3, -dct_cat4, /* cat3 = "111100",
                                       cat4 = "111101" */
          -dct_cat5, -dct_cat6 /* cat5 = "111110",
                                       cat6 = "111111" */
      };
```

The length function of T can be verified as being (2, 2, 3, 3, 4, 4, 5, 5, 6, 6, 6, 6).

The array T above is structured to facilitate parsing and tree representation. For the purpose of coding and transmission, T may be transformed into another array T' to facilitate entropy coding, where the transformation from T to T' is invertible, i.e., T can be fully reconstructed from T'. For example, if T[i] is positive, then T[i] $\geq$ 2 and is always even. As such, instead of coding T[i] directly, the encoder might encode T'[i] = (T[i]-2)>>1. On the decoder side, after T'[i] is decoded, T[i] can be reconstructed as T[i] = T'[i]*2 + 2.

The encoder may determine the new tree structure by first determining or estimating the marginal token distribution for the set of blocks, *i.e.* the normalized frequency with which each token occurs in coding the set of blocks. From this information, the encoder may then determine a coding tree (*e.g.* a Huffman coding tree) that better fits the marginal distribution. In some implementations, the encoder may determine a coding tree by using the un-normalized empirical distribution that consists of frequency counts of tokens instead of the normalized marginal distribution.

In some embodiments, the encoder may filter the marginal token distribution or equivalently the un-normalized empirical distribution before determining a coding tree that fits the marginal distribution. For example, frequency counts less than a threshold may be replaced by a default value (e.g. 0, 1, or a known positive integer) in the un-normalized empirical distribution. Without losing generality, suppose that the un-normalized empirical distribution is given by $(f_0, f_1, \cdots, f_{11})$, where $f_i$ denotes the frequency count of token $i$, $0 \leq i \leq 11$. Then for each $i$, if $f_i < Th$, where $Th$ denotes a threshold, $\hat{f}_i = 1$; otherwise $\hat{f}_i = f_i$. The resulting vector $(\hat{f}_0, \hat{f}_1, \cdots, \hat{f}_{11})$ is then used to determine a coding tree. After filtering, we see that tokens with frequency counts less than the threshold are treated equally and would have deterministic and limited impact in the process of determining a coding tree. Thus, by using filtering the encoder avoids overfitting in determining a coding tree when there is not enough empirical data. Note that the threshold may be a constant determined *a priori* or as a function of the total number of tokens, i.e. the sum of all frequency counts.

It will be appreciated that the entire tree may not be signaled in some embodiments in cases where only a partial update of the tree is implemented. This may be used to balance the cost of signaling a new binarizer and the benefit of bin savings. For example, one might want to signal a new tree based on the default tree in 5 where

1. the changes are limited to the subtree corresponding to {dct_eob, DCT_0, DCT_1, DCT_2, DCT_3, DCT_4}; and

2. the subtree rooted at internal node (12) remains unchanged.

## Updating Probabilities

As noted above, the binary probability distributions at internal nodes of the VP8 and VP9 default tree is stored in the coeff_probs array. If a new tree is used, the decoder may need to map the probability distributions associated with the existing default tree (in coeff_probs) to the new tree.

Let $T_1$ and $T_2$ denote two binary trees that represent the same alphabet $A = \{a_0, \cdots a_{N-1}\}$ with $N$ symbols. Assume that both $T_1$ and $T_2$ are full, and thus they have exactly $N$-1 internal nodes. Let $(p_{1,0}, \cdots p_{1,N-2})$ denote the binary probability distributions at the $N$-1 internal nodes of $T_1$: for example, $p_{1,0}$ denote the probability of 1 (or equivalently taking the right branch) at the first internal node (root), $p_{1,1}$ denote the probability of 1 (or equivalently taking the right branch) at the second internal node, and so on. Note that the order of labelling the internal nodes does not matter, in other words, any known order would work with the present solution. Similarly, let $(p_{2,0}, \cdots p_{2,N-2})$ denote the binary probability distributions at the $N$-1 internal nodes of $T_2$. Suppose that $(p_{1,0}, \cdots p_{1,N-2})$ and $(p_{2,0}, \cdots p_{2,N-2})$ are learned from the same marginal distribution over $A$. Then the challenge is to map $(p_{1,0}, \cdots p_{1,N-2})$ to $(p_{2,0}, \cdots p_{2,N-2})$ and vice versa.

Let $(q_0, \cdots q_{N-1})$ denote the common marginal distribution over $A$, where $q_i$, $0 \leq i < N$, denotes the probability of $a_i$. Then the challenge is solved by using the following two-stage process:

1. Determine $(q_0, \cdots q_{N-1})$ from $(p_{1,0}, \cdots p_{1,N-2})$ in $T_1$.

2. Determine $(p_{2,0}, \cdots p_{2,N-2})$ from $(q_0, \cdots q_{N-1})$ in $T_2$.

The first stage above can be achieved by using a tree traversal method, *e.g.,* depth-first or breadth-first, to populate the probabilities from top to bottom (top-down). Below is an illustrative example of a depth-first iterative method, where without losing generality it is assumed root node is labelled "0" and corresponds to $p_{1,0}$:

```
dfp2q()
   dfp2q_iter(root, 1);
end
dfp2q_iter(node, prob)
   if node is a leaf node
      i= node.a; //node.a stores the index of a symbol in //A.
      q_i = prob;
   else
      j= node.label; //node.label stores the label of the
                                      //internal node.
      dfp2q_iter(node.leftchild, prob*(1-p_{1,j}));
      dfp2q_iter(node.rightchild, prob*p_{1,j});
   end
end
```

As a further example, a breadth-first approach to the first stage may be described as:

```
bfp2q(root)
   root.prob = 1;
   Q = empty queue;
   Q.enqueue(root);
   While not Q.empty do
      node = Q.dequeue();
      if node is a leaf node
         i= node.a; //node.a stores the index of a symbol //in A.
         q_i = node.prob;
      else
         j= node.label; //node.label stores the label of the
                                         //internal node.
         node.leftchild.prob = node.prob*(1-p_{1,j});
         Q.enqueue(node.leftchild);
         node.rightchild.prob = node.prob*p_{1,j};



         Q.enqueue(node.rightchild);
      end
   end
end
```

In a similar manner, the second stage can be implemented through traversal of the tree to populate the probability from bottom to top (bottom-up). An example method is illustrated in the following pseudo-code, using a post-order depth-first transversal method:

```
dfq2p()
    dfq2p_iter(root);
end
dfq2p_iter(node)
    if node is a leaf node
        i= node.a; //node.a stores the index of a symbol in //A.
        node.prob = q_i ;
        return;
    else
        dfq2p_iter(node.leftchild);
        dfq2p_iter(node.rightchild);
        node.prob = node.rightchild.prob+node.leftchild.prob;
        j= node.label; //node.label stores the label of the
                                                //internal node.
        p_{2,j} = node.rightchild.prob/node.prob;
    end
end
```

Accordingly, in some embodiments, the following changes may be made to the process of updating probabilities so as to reduce signaling overhead. Instead of signalling an updating flag for each of the (*e.g.* 1056) entries in coeff_probs, the present solution may infer a flag (that is not present in the bitstream) as follows. Suppose that a binarizer (or equivalently a coefficient coding tree) is given. Note that each entry in coeff_probs corresponds to an internal node in the coefficient coding tree. If an updating flag associated with an entry in coeff_probs is signalled to be 1 and the entry corresponds to a node *a*, then all updating flags associated with entries that correspond to nodes in the path from the root to node *a* are inferred to be 1 and do not need to be signalled in the bitstream. For example, if the updating flag associated with node (8) in Figure 5 is signalled to be 1, then the updating flags associated with nodes (6), (4), (2), (0) are inferred to be 1 and do not need to be signalled in the bitstream.

In another embodiment, an updating flag may be associated with a level in the coefficient coding tree, where the root node is at level 0, its children are at level 1, and so on. If an updating flag associated with level L>=0 is signalled to be 1, then the updating flags associated with all levels 1 < L, i.e., closer to the root level, are inferred to be 1.

It will be appreciated that the above-described tree traversal methods are examples. Other traversal methods, for example, iterative deepening depth-first search, might be used (e.g. to satisfy application requirements like storage complexity, call stack limitation, etc.). It will also be understood that, in some embodiments, fixed-point arithmetic might be used in populating the probabilities in the two-stage mapping process for probabilities described above. Note that it is possible to use a different (higher) precision or even floating-point arithmetic in intermediate steps for better accuracy in the end results.

### *Decoder-built binarizer based on probabilities*

In the above-described embodiments, the encoder determines/selects a binarizer and then signals the selection to the decoder. In one case, the encoder communicates its selection from among a plurality of predefined binarizers. In another case, the encoder specifies the binarizers. For example, it may send data specifying the structure and assignment of tokens for constructing the modified binarizer. In another example, it may signal the changes to a default structure or assignment of tokens that the decoder may use to create the modified binarizer.

In yet a further embodiment, the encoder does not specify the structure or tokens of a newly-determined coding tree or other binarizer, but instead sends updated probability information and an indication that the decoder should build a new binarizer based on the updated probability information.

Using the VP8 and VP9 coding tree as an example again, the encoder may communicate the internal node probability distribution, *e.g.* the coeff_probs array, or changes to that array. The encoder further signals whether the decoder should build a new tree or not. The encoder may determine whether a new tree is warranted based upon the degree of difference between the coeff_probs probability distribution and the probabilities for which the default coding tree was originally designed. More than a threshold deviation between one or more of the internal node probabilities may signal that a new coding tree should be used. In another embodiment, the encoder obtains the marginal distribution of tokens and determines from those probability values whether a new tree should be constructed. The encoder may obtain the marginal distribution of tokens from the internal node probabilities using one of the tree traversal techniques described above. More than a threshold change in the marginal distribution of tokens may determine that a new tree should be constructed. The encoder may instruct the decoder to build a new tree using a flag in a header, for example.

The decoder may then use the above-described tree traversal techniques to determine, from the updated coeff_probs probability distributions the corresponding marginal distribution of the tokens. The marginal distribution of the tokens may then be used to determine a suitable coding tree that results in fewer bins used for coding the data.

In yet a further embodiment, the encoder does not indicate whether the decoder should or should not create a new binarizer. Instead, the decoder determines on its own whether a new tree should be constructed and used. The determination may be based on whether there has been more than a threshold change in the probability distributions specified in the updated coeff_probs array. In another embodiment, the decoder calculates the marginal distribution of tokens whenever the coeff_probs array is updated and determines from the marginal distribution of tokens whether a new tree should be constructed, for example based on whether the marginal distribution of tokens has deviated more than a threshold amount from the probabilities upon which the default tree (or current tree if using a modified coding tree) is based.

### *Context-Adaptive Binarizer Selection*

In some of the above-described embodiments, a single binarizer is selected for coding tokens for a set of blocks (*e.g.* frame/picture). In another embodiment, multiple available binarizers may be used within a set of blocks, *e.g.* picture/frame, and for a current non-binary symbol, one binarizer is selected from among the multiple available binarizers according to the contextual information, *e.g.* a context derived for the symbol.

This solution is illustrated using elements of VP8 and VP9 as an example, in which:

1. There are 96 contexts defined for 12 tokens.

2. Before encoding a token, a context is derived from the known information:

   plane type, coeff positions, and nearby coefficients.

3. Before decoding a token, a context is derived from the known information: plane type, coeff positions, and nearby coefficients

4. For each context, we can estimate an empirical distribution over the tokens in a picture/frame.

The context is known to both the encoder and the decoder in VP8 and VP9 before encoding and decoding a token, respectively.

In the present embodiment, the context is used as the basis to select a binarizer from a finite set of candidate binarizers. In one example, in the picture/frame header, a table that maps the 96 contexts to binarizers may be signaled in the bitstream; and when such a table is not present in the bitstream, a default table may be used. Let $B = \{T_0, T_1, \cdots, T_N\}$, $N > 1$, denote a finite set of binarizers. The table might be defined as an array M [4] [8] [3] where each entry is an index in *B*, i.e., for the context given by (a, b, c), where $0 \leq a < 4$, $0 \leq b < 8$, and $0 \leq c < 3$, $T_{M[a][b][c]}$ in *B* is the binarizer selected.

Once the table M is parsed, the decoder can then select the binarizer for each token to be decoded according to the derived context. Furthermore, we note that the probability distributions in coeff_probs[a][b][c][] should now be interpreted according to the binarizer $T_{M[a][b][c]}$ selected for the context given by (a, b, c).

In summary, an example decoder may use the following process to decode a token $v$:

   D1. Determine the context (a, b, c) for the token as defined in VP#.

   D2. Select the binarizer T as $T_{M[a][b][c]}$.

   D3. Decode $v$ by using coeff_probs[a][b][c] and T.

Correspondingly, an example encoder may use the following process to encode a token $v$:

   E1. Determine the context (a, b, c) for the token as defined in VP#.

   E2. Select the binarizer T as $T_{M[a][b][c]}$.

   E3. Binarize $v$ by using T into a binary string $T(v) = b_0 b_1 \cdots b_{l(v)}$, where $l(v)$ is the number of bins, and $T(v)$ is the

path from the root to the leaf corresponding to $v$ in T.

E4. Encode $T(v)$ by using coeff_probs[a][b][c].

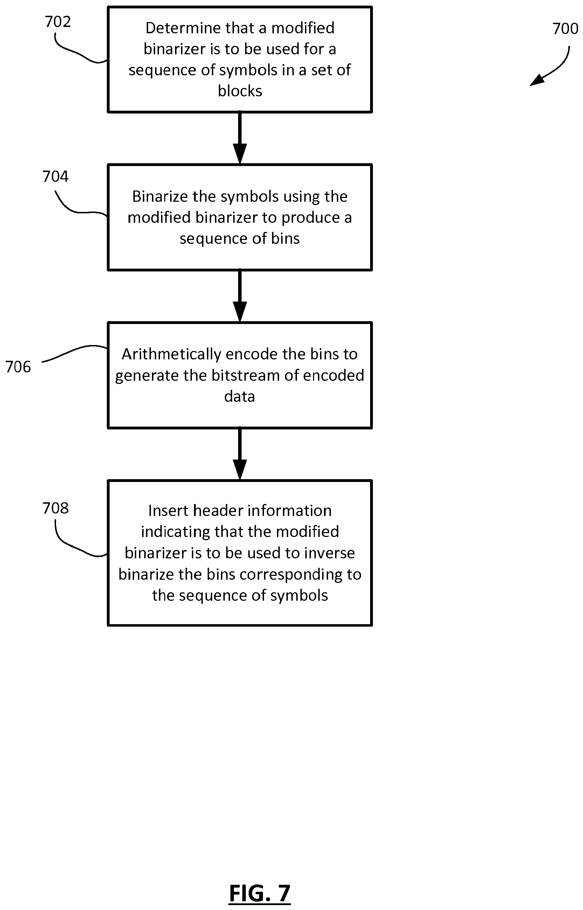

Reference is now made to Figure 7, which shows a flowchart for an example encoding process 700 for encoding an image in an image or video encoder. The process 700 is implemented using a coding architecture that includes an arithmetic encoder to convert bins into a bitstream of encoded data using arithmetic coding (whether binary arithmetic coding or multi-level arithmetic coding). The process 700 presumes that the image has been subject to an image or video coding process to create a sequence of symbols. Example symbols may include the magnitude of quantized transform domain coefficients, or "tokens" representative of quantized transform domain coefficients.

The coding architecture also includes a default binarizer. One example of a default binarizer is the default coding tree for tokens in VP8/VP9.

The process 700 includes an operation 702 of determining that a modified binarizer is to be used instead of the default binarizer prescribed for a sequence of symbols. The determination to use the modified binarizer may be based, for example, on an assessment (measured or estimated) of normalized frequency of occurrence of the symbols in the image and an assessment of the difference between those frequencies and the marginal probabilities for those symbols upon which the default binarizer is based.

In some embodiments, operation 702 may include constructing the modified binarizer based on the measured or estimated normalized frequency of occurrence of the symbols. In some embodiments, operation 702 may include selecting the modified binarizer from among a plurality of pre-constructed/pre-established binarizers.

In operation 704 the sequence of symbols is binarized using the modified binarizer to generate a sequence of bins. The sequence of bins is then arithmetically encoded using the arithmetic encoder in operation 706 to produce the bitstream of encoded data.

In order to ensure that the decoder may properly reconstruct the image, the process 700 further in includes an operation 708 of inserting header information into the bitstream. The header information indicates that the modified binarizer is to be used for inverse binarizing the sequence of bins corresponding to the sequence of symbols. It will be appreciated that the header information may be placed in a header corresponding to a series of blocks, such as a slice, frame, picture, group-of-pictures, or other collection of blocks. The header information indicates that, for at least a particular sequence of symbols in that series of blocks, e.g. tokens, that the decoder is to use a modified binarizer instead of the default binarizer.

In the simplest case, the header information includes a flag indicating that a modified binarizer is to be used. The decoder may then use side information (such as probability information) to either select or construct a binarizer. In some other cases, the header information specifies the allocation of symbols to leaf nodes of a default structure. In yet other cases, the header information specifies a new or modified structure for a coding tree. In further cases, other details of the binarizer construction may be specified in the header information.

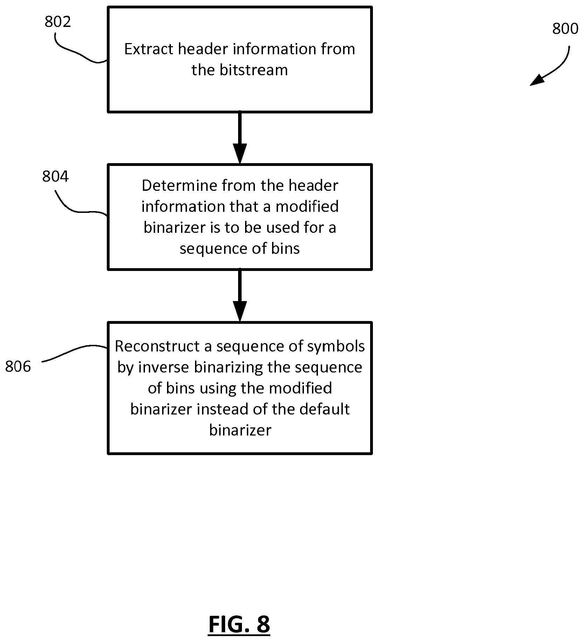

Reference is now made to Figure 8, which shows a flowchart of an example decoding process 800. The process 800 is implemented by an example decoder for images or video that includes an arithmetic decoder and includes a default binarizer (for inverse binarizing bins to reconstruct symbols). The example process 800 includes extracting the header information from the bitstream, as indicated by operation 802.

The header information indicates whether to use a modified binarizer or the default binarizer. Accordingly, in operation 804, the decoder determines, from the header information, that a modified binarizer is to be used instead of the default binarizer. Note that in some cases this may be an explicit instruction in the header information, such as a flag specifying that a modified binarizer is to be used, or an index specifying a particular modified binarizer from among a plurality of pre-determined binarizer options. In some other cases, the header information specifies the modified binarizer. For example, it may specify changes to the default binarizer, such as a reallocation of symbols among leaf nodes of a coding tree, or it may specify changes to the structure of the coding tree. In yet other examples, the header information may specify all or part of the structure of the binarizer, such as the structure of a Huffman tree and the allocation of symbols among its leaf nodes. Any in yet other embodiments, the header information may provide data, such as probability information (*e.g.* the coeff_probs array) from which the decoder may determine that a modified binarizer is to be used instead of the default binarizer.

In operation 806, the modified binarizer is used to inverse binarize the sequence of bins (which has been arithmetically decoded from the bitstream) to reconstruct the sequence of symbols.

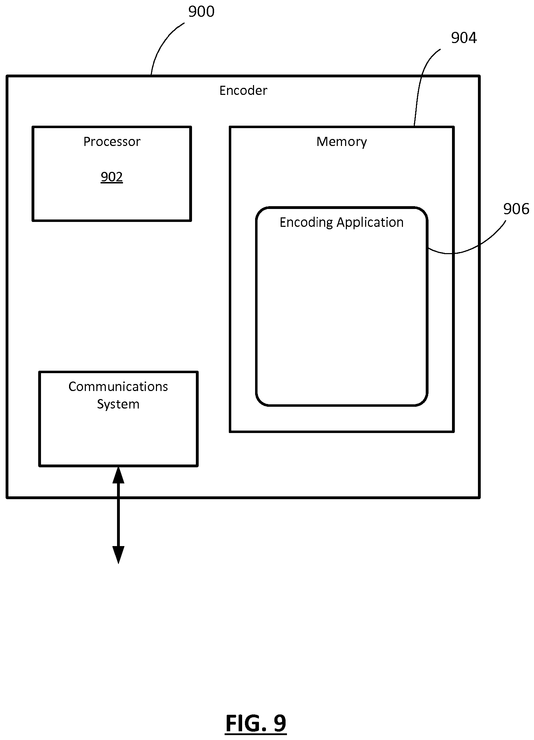

Reference is now made to Figure 9, which shows a simplified block diagram of an example embodiment of an encoder 900. The encoder 900 includes a processor 902, memory 904, and an encoding application 906. The encoding application 906 may include a computer program or application stored in memory 904 and containing instructions that, when executed, cause the processor 902 to perform operations such as those described herein. For example, the encoding application 906 may encode and output bitstreams encoded in accordance with the processes described herein. It will be understood that the encoding application 906 may be stored in on a non-transitory computer-readable medium, such as a compact disc, flash memory device, random access memory, hard drive, etc. When the instructions are executed, the result is configuring the 902 processor so as to create a special-purpose processor that implements the described process(es). Such a processor may be referred to as a "processor circuit" or "processor circuitry" in some examples.

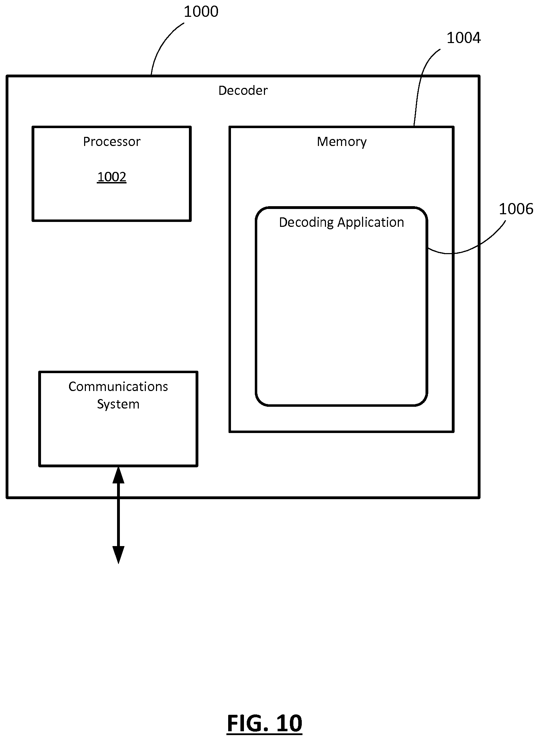

Reference is now also made to Figure 10, which shows a simplified block diagram of an example embodiment of a decoder 1000. The decoder 1000 includes a processor 1002, a memory 1004, and a decoding application 1006. The decoding application 1006 may include a computer program or application stored in memory 1004 and containing instructions that, when executed, cause the processor 1002 to perform operations such as those described herein. It will be understood that the decoding application 1006 may be stored in on a computer-readable medium, such as a compact disc, flash memory device, random access memory, hard drive, etc. When the instructions are executed, the result is configuring the 1002 processor so as to create a special-purpose processor that implements the described process(es). Such a processor may be referred to as a "processor circuit" or "processor circuitry" in some examples.

It will be appreciated that the decoder and/or encoder according to the present application may be implemented in a number of computing devices, including, without limitation, servers, suitably-programmed general purpose computers, audio/video encoding and playback devices, set-top television boxes, television broadcast equipment, and mobile devices. The decoder or encoder may be implemented by way of software containing instructions for configuring a processor or processors to carry out the functions described herein. The software instructions may be stored on any suitable non-transitory computer-readable memory, including CDs, RAM, ROM, Flash memory, etc.

It will be understood that the decoder and/or encoder described herein and the module, routine, process, thread, or other software component implementing the described method/process for configuring the encoder may be realized using standard computer programming techniques and languages. The present application is not limited to particular processors, computer languages, computer programming conventions, data structures, other such implementation details. Those skilled in the art will recognize that the described processes may be implemented as a part of computer-executable code stored in volatile or non-volatile memory, as part of an application-specific integrated chip (ASIC), etc.

Certain adaptations and modifications of the described embodiments can be made. Therefore, the above discussed embodiments are considered to be illustrative and not restrictive.

**Claims**

1. A method (800) of decoding an image in a video or image decoder from a bitstream, the bitstream having header information for a set of blocks, the decoder having an arithmetic decoder to convert the bitstream into bins, the decoder including a default binarizer for inverse binarizing bins to reconstruct symbols, the method (800) comprising:

    obtaining (802) the header information from the bitstream;
    determining (804) from the header information that a modified binarizer is to be used, instead of the default binarizer, with respect to a sequence of bins for the set of blocks, and in response selecting the modified binarizer for the sequence of bins;
    arithmetic decoding the bitstream into the sequence of bins; and
    reconstructing (806) a sequence of symbols from the sequence of bins using the selected binarizer to inverse binarize the sequence of bins,

    wherein the default binarizer comprises a first coding tree for the inverse binarization, the modified binarizer comprises a second coding tree for the inverse binarization having a different tree structure of internal and leaf nodes from the first coding tree; a symbol represented by a path in a coding tree consisting of branches from the internal nodes starting from the root node of the coding tree to a respective leaf node; the first and second coding trees comprising internal node probabilities associated with the branches of the internal nodes of the respective coding tree; the internal node probabilities of the selected binarizer are used by the arithmetic decoder for arithmetic decoding;

    wherein the header information comprises information specifying the structure of the second coding tree and an allocation of symbols to leaf nodes of the second coding tree;
    wherein the first and second coding trees are used for decoding tokens; wherein a token is a binary string that indicates the magnitude of a quantized transform domain coefficient; and wherein the second coding tree is determined to satisfy for any $i \neq j$: if the number of times that token $i$ appears in the set of blocks $f_i$ is larger than the number of times that token $j$ appears in the set of blocks $f_j$, then the number of bins used to represent token $i$ by using the second coding tree $l_i$ is less than or equal to the number of bins used to represent token $j$ by using the second coding tree $l_j$;
    the method (800) further comprising:

generating the second coding tree based on the header information.

2. The method (800) claimed in claim 1, wherein the determining (804) that the modified binarizer is to be used is irrespective of contexts determined for the sequence of symbols.

3. The method (800) claimed in any previous claim, further comprising determining context based on a context model, and wherein determining from the header information that the modified binarizer is to be used is further based, but not solely based, on the determined context.

4. A decoder (1000) for decoding an image from a bitstream, the bitstream having header information for a set of blocks, the decoder (1000) comprising:

a processor (1002);
memory (1004);
an arithmetic decoder adapted to convert the bitstream into bins;
a default binarizer adapted to inverse binarize bins to reconstruct symbols;
a binarizer selector adapted to determine from the header information that a modified binarizer is to be used, instead of the default binarizer, with respect to a sequence of bins, and in response to select the modified binarizer for the sequence of bins; and
the selected binarizer adapted to reconstruct a sequence of symbols from the sequence of bins so as to inverse binarize the sequence of bins,
wherein the default binarizer comprises a first coding tree for the inverse binarization, the modified binarizer comprises a second coding tree for the inverse binarization having a different tree structure of internal and leaf nodes from the first coding tree; a symbol represented by a path in a coding tree consisting of branches from the internal nodes starting from the root node of the coding tree to a respective leaf node; the first and second coding trees comprising internal node probabilities associated with the branches of the internal nodes of the respective coding tree; the internal node probabilities of the selected binarizer are used by the arithmetic decoder for arithmetic decoding;
wherein the header information comprises information specifying the structure of the second coding tree and an allocation of symbols to leaf nodes of the second coding tree;
wherein the first and second coding trees are used for decoding tokens; wherein a token is a binary string that indicates the magnitude of a quantized transform domain coefficient; and wherein the second coding tree is determined to satisfy for any $i \neq j$: if the number of times that token $i$ appears in the set of blocks $f_i$ is larger than the number of times that token $j$ appears in the set of blocks $f_j$, then the number of bins used to represent token $i$ by using the second coding tree $l_i$ is less than or equal to the number of bins used to represent token $j$ by using the second coding tree $l_j$; and
wherein the decoder (1000) is adapted to generate the second coding tree based on the header information.

5. The decoder (1000) claimed in claim 4, wherein the decoder (1000) includes a context determiner, and the binarizer selector determines that the modified binarizer is to be used irrespective of contexts determined by the context determiner for the sequence of symbols.

6. The decoder (1000) claimed in claim 4, further comprising a context determiner to determine context based on a context model, and wherein the determination by the binarizer selector that the modified binarizer is to be used is further based, but not solely based, on the determined context.

7. A method (700) of encoding an image within an image or video encoder to generate a bitstream of encoded data, the image having a set of blocks, the encoder having an arithmetic encoder to convert bins into the bitstream of encoded data, the encoder including a default binarizer for binarizing symbols to bins, the method (700) comprising:

determining (702), for the set of blocks, that a modified binarizer is to be used, instead of the default binarizer, to binarize a sequence of symbols within that set of blocks, and in response selecting the modified binarizer for the sequence of symbols, the determining based upon a respective frequency of occurrence for each symbol within the set of blocks and based upon the expectation that the modified binarizer will result in a shorter binary sequence than would otherwise be the case with the default binarizer;
binarizing (704) the sequence of symbols using the selected binarizer to generate a sequence of bins;
arithmetically encoding (706) the sequence of bins using the arithmetic encoder to generate the bitstream of encoded data; and

inserting (708) header information in the bitstream that indicates that the modified binarizer is to be used, instead of the default binarizer, with respect to the sequence of bins,

wherein the default binarizer comprises a first coding tree for the binarization, the modified binarizer comprises a second coding tree for the binarization having a different tree structure of internal and leaf nodes from the first coding tree; a symbol represented by a path in a coding tree consisting of branches from the internal nodes starting from the root node of the coding tree to a respective leaf node; the first and second coding trees comprising internal node probabilities associated with the branches of the internal nodes of the respective coding tree; the internal node probabilities of the selected binarizer are used by the arithmetic encoder for arithmetic encoding;

wherein the header information comprises information specifying the structure of the second coding tree and an allocation of symbols to leaf nodes of the second coding tree;
wherein the first and second coding trees are used for encoding tokens; wherein a token is a binary string that indicates the magnitude of a quantized transform domain coefficient;
wherein the second coding tree is determined based on the respective symbol probabilities and by determining the internal node probabilities for the second coding tree; and
wherein the second coding tree is determined to satisfy for any $i \neq j$: if the number of times that token $i$ appears in the set of blocks $f_i$ is larger than the number of times that token $j$ appears in the set of blocks $f_j$, then the number of bins used to represent token $i$ by using the second coding tree $l_i$ is less than or equal to the number of bins used to represent token $j$ by using the second coding tree $l_j$.

8. A non-transitory processor-readable medium storing processor-executable instructions for decoding an image in a video or image decoder from a bitstream, the bitstream having header information for a set of blocks, the decoder having an arithmetic decoder to convert the bitstream into bins, the decoder including a default binarizer for inverse binarizing bins to reconstruct symbols, wherein the processor-executable instructions comprise instructions to perform the method of any of claims 1 to 3.

**Patentansprüche**

1. Verfahren (800) zum Decodieren eines Bilds in einem Video- oder Bilddecodierer aus einem Bitstrom, wobei der Bitstrom Headerinformation für einen Satz von Blöcken aufweist, der Decodierer einen arithmetischen Decodierer zum Konvertieren des Bitstroms in Bits aufweist, der Decodierer einen Standardbinarisierer zum inversen Binarisieren von Bins zu Rekonstruktionszeichen enthält, das Verfahren (800) umfassend:

Erhalten (802) der Headerinformation aus dem Bitstrom;
Bestimmen (804) aus der Headerinformation, dass ein modifizierter Binarisierer anstelle des Standardbinarisierers bezüglich einer Sequenz von Bins für den Satz von Blöcken benutzt werden soll, und, in Reaktion darauf, Auswählen des modifizierten Binarisierers für die Sequenz von Bins;
arithmetisches Decodieren des Bitstroms in die Sequenz von Bins; und
Rekonstruieren (806) einer Sequenz von Zeichen aus der Sequenz von Bins unter Benutzung des ausgewählten Binarisierers zum inversen Binarisieren der Sequenz von Bins,
wobei der Standardbinarisierer einen ersten Codierbaum für die inverse Binarisierung umfasst, wobei der modifizierte Binarisierer einen zweiten Codierbaum für die inverse Binarisierung mit einer anderen Baumstruktur von internen und Blattknoten als der erste Codierbaum umfasst; wobei ein Zeichen durch einen Pfad in einem Codierbaum dargestellt wird, der aus Zweigen von den internen Knoten beginnend vom Wurzelknoten des Codierbaums zu einem jeweiligen Blattknoten besteht; wobei die ersten und zweiten Codierbäume interne Knotenwahrscheinlichkeiten umfassen, die mit den Zweigen der internen Knoten des jeweiligen Codierbaums assoziiert sind; wobei die internen Knotenwahrscheinlichkeiten des ausgewählten Binarisierers vom arithmetischen Decodierer zum arithmetischen Decodieren benutzt werden;
wobei die Headerinformation Information umfasst, die die Struktur des zweiten Codierbaums und eine Zuweisung von Zeichen zu Blattknoten des zweiten Codierbaums spezifiziert;
wobei die ersten und zweiten Codierbäume zum Decodieren von Token benutzt werden; wobei ein Token eine Binärzeichenfolge ist, die die Größenordnung eines quantifizierten Transformationsdomänenkoeffizienten anzeigt; und wobei der zweite Codierbaum zum Erfüllen für jegliche $i \neq j$ bestimmt ist: wenn die Anzahl von Malen, die Token $i$ im Satz von Blöcken $f_i$ auftritt, größer als die Anzahl von Malen ist, die Token $j$ im Satz von Blöcken $f_j$ auftritt, dann ist die Anzahl von Bins, die zum Darstellen von Token $i$ durch Benutzen des zweiten Codierbaums $l_i$ benutzt werden, kleiner als die oder

gleich der Anzahl von Bins, die zum Darstellen von Token $j$ durch Benutzen des zweiten Codierbaums $l_j$ benutzt werden;
wobei das Verfahren (800) ferner umfasst:
Generieren des zweiten Codierbaums basierend auf der Headerinformation.

2. Verfahren (800) nach Anspruch 1, wobei das Bestimmen (804), dass der modifizierte Binarisierer benutzt werden soll, unabhängig von Kontexten ist, die für die Sequenz von Zeichen bestimmt werden.

3. Verfahren (800) nach einem der vorhergehenden Ansprüche, ferner umfassend Bestimmen von Kontext basierend auf einem Kontextmodell, und wobei Bestimmen aus der Headerinformation, dass der modifizierte Binarisierer benutzt werden soll, ferner auf dem bestimmten Kontext basiert, jedoch nicht nur darauf basiert.

4. Decodierer (1000) zum Decodieren eines Bilds aus einem Bitstrom, wobei der Bitstrom Headerinformation für einen Satz von Blöcken aufweist, der Decodierer (1000) umfassend:

einen Prozessor (1002);
Speicher (1004);
einen arithmetischen Decodierer, der zum Konvertieren des Bitstroms in Bins geeignet ist;
einen Standardbinarisierer, der zum inversen Binarisieren von Bins zu Rekonstruktionszeichen geeignet ist;
einen Binarisiererselektor, der zum Bestimmen aus der Headerinformation, dass ein modifizierter Binarisierer anstelle des Standardbinarisierers bezüglich einer Sequenz von Bins für den Satz von Blöcken benutzt werden soll, und, in Reaktion darauf, zum Auswählen des modifizierten Binarisierers für die Sequenz von Bins geeignet ist; und
den ausgewählten Binarisierer, der zum Rekonstruieren einer Sequenz von Zeichen aus der Sequenz von Bins zum inversen Binarisieren der Sequenz von Bins geeignet ist,
wobei der Standardbinarisierer einen ersten Codierbaum für die inverse Binarisierung umfasst, wobei der modifizierte Binarisierer einen zweiten Codierbaum für die inverse Binarisierung mit einer anderen Baumstruktur von internen und Blattknoten als der erste Codierbaum umfasst; wobei ein Zeichen durch einen Pfad in einem Codierbaum dargestellt wird, der aus Zweigen von den internen Knoten beginnend vom Wurzelknoten des Codierbaums zu einem jeweiligen Blattknoten besteht; wobei die ersten und zweiten Codierbäume interne Knotenwahrscheinlichkeiten umfassen, die mit den Zweigen der internen Knoten des jeweiligen Codierbaums assoziiert sind; wobei die internen Knotenwahrscheinlichkeiten des ausgewählten Binarisierers vom arithmetischen Decodierer zum arithmetischen Decodieren benutzt werden;
wobei die Headerinformation Information umfasst, die die Struktur des zweiten Codierbaums und eine Zuweisung von Zeichen zu Blattknoten des zweiten Codierbaums spezifiziert;
wobei die ersten und zweiten Codierbäume zum Decodieren von Token benutzt werden; wobei ein Token eine Binärzeichenfolge ist, die die Größenordnung eines quantifizierten Transformationsdomänenkoeffizienten anzeigt; und wobei der zweite Codierbaum zum Erfüllen von jeglichem $i \neq j$ bestimmt ist: wenn die Anzahl von Malen, die Token $i$ im Satz von Blöcken $f_i$ auftritt, größer als die Anzahl von Malen ist, die Token $j$ im Satz von Blöcken $f_j$ auftritt, dann ist die Anzahl von Bins, die zum Darstellen von Token $i$ durch Benutzen des zweiten Codierbaums $l_i$ benutzt werden, kleiner als die oder gleich der Anzahl von Bins, die zum Darstellen von Token $j$ durch Benutzen des zweiten Codierbaums $l_j$ benutzt werden; und
wobei der Decodierer (1000) zum Generieren des zweiten Codierbaums basierend auf der Headerinformation geeignet ist.

5. Decodierer (1000) nach Anspruch 4, wobei der Decodierer (1000) einen Kontextbestimmer enthält und der Binarisiererselektor unabhängig von Kontexten, die durch den Kontextbestimmer für die Sequenz von Zeichen bestimmt werden, bestimmt, dass der modifizierte Binarisierer benutzt werden soll.

6. Decodierer (1000) nach Anspruch 4, ferner umfassend einen Kontextbestimmer zum Bestimmen von Kontext basierend auf einem Kontextmodell, und wobei die Bestimmung durch den Binarisiererselektor, dass der modifizierte Binarisierer benutzt werden soll, ferner auf dem bestimmten Kontext basiert, jedoch nicht nur darauf basiert.

7. Verfahren (700) zum Codieren eines Bilds innerhalb eines Bild- oder Videocodierers zum Generieren eines Bitstroms von codierten Daten, wobei das Bild einen Satz von Blöcken aufweist, wobei der Codierer einen arithmetischen Codierer zum Konvertieren von Bins in den Bitstrom von codierten Daten aufweist, wobei der Codierer einen Standardbinarisierer zum Binarisieren von Zeichen zu Bins enthält, das Verfahren (700) umfassend:

Bestimmen (702), für den Satz von Blöcken, dass ein modifizierter Binarisierer anstelle des Standardbinarisierers zum Binarisieren einer Sequenz von Zeichen innerhalb dieses Satzes von Blöcken benutzt werden soll, und, in Reaktion darauf, Auswählen des modifizierten Binarisierers für die Sequenz von Zeichen, wobei das Bestimmen auf einer jeweiligen Häufigkeit des Auftretens für jedes Zeichen innerhalb des Satzes von Blöcken basiert und auf der Erwartung basiert, dass der modifizierte Binarisierer zu einer kürzeren Binärsequenz führt, als es sonst mit dem Standardbinarisierer der Fall wäre;

Binarisieren (704) der Sequenz von Zeichen unter Benutzung des ausgewählten Binarisierers zum Erzeugen einer Sequenz von Bins;

arithmetisches Codieren (706) der Sequenz von Bins unter Benutzung des arithmetischen Codierers zum Erzeugen des Bitstroms von codierten Daten; und

Einfügen (708) von Headerinformation in den Bitstrom, die anzeigt, dass der modifizierte Binarisierer anstelle des Standardbinarisierers bezüglich der Sequenz von Bins benutzt werden soll,

wobei der Standardbinarisierer einen ersten Codierbaum für die Binarisierung umfasst, wobei der modifizierte Binarisierer einen zweiten Codierbaum für die Binarisierung mit einer anderen Baumstruktur von internen und Blattknoten als der erste Codierbaum umfasst; wobei ein Zeichen durch einen Pfad in einem Codierbaum dargestellt wird, der aus Zweigen von den internen Knoten beginnend vom Wurzelknoten des Codierbaums zu einem jeweiligen Blattknoten besteht;

wobei die ersten und zweiten Codierbäume interne Knotenwahrscheinlichkeiten umfassen, die mit den Zweigen der internen Knoten des jeweiligen Codierbaums assoziiert sind; wobei die internen Knotenwahrscheinlichkeiten des ausgewählten Binarisierers vom arithmetischen Codierer zum arithmetischen Codieren benutzt werden;

wobei die Headerinformation Information umfasst, die die Struktur des zweiten Codierbaums und eine Zuweisung von Zeichen zu Blattknoten des zweiten Codierbaums spezifiziert;

wobei die ersten und zweiten Codierbäume zum Codieren von Token benutzt werden; wobei ein Token eine Binärzeichenfolge ist, die die Größenordnung eines quantifizierten Transformationsdomänenkoeffizienten anzeigt;

wobei der zweite Codierbaum basierend auf den jeweiligen Zeichenwahrscheinlichkeiten und durch Bestimmen der internen Knotenwahrscheinlichkeiten für den zweiten Codierbaum bestimmt wird; und

wobei der zweite Codierbaum zum Erfüllen für jegliche $i \neq j$ bestimmt ist: wenn die Anzahl von Malen, die Token $i$ im Satz von Blöcken $f_i$ auftritt, größer als die Anzahl von Malen ist, die Token $j$ im Satz von Blöcken $f_j$ auftritt, dann ist die Anzahl von Bins, die zum Darstellen von Token $i$ durch Benutzen des zweiten Codierbaums $l_i$ benutzt werden, kleiner als die oder gleich der Anzahl von Bins, die zum Darstellen von Token $j$ durch Benutzen des zweiten Codierbaums $l_j$ benutzt werden.

8. Nichtflüchtiges prozessorlesbares Medium, das prozessorausführbare Anweisungen zum Decodieren eines Bilds in einem Video- oder Bilddecodierer aus einem Bitstrom speichert, wobei der Bitstrom Headerinformation für einen Satz von Blöcken aufweist, der Decodierer einen arithmetischen Decodierer zum Konvertieren des Bitstroms in Bits aufweist, der Decodierer einen Standardbinarisierer zum inversen Binarisieren von Bins zu Rekonstruktionszeichen enthält, wobei die prozessorausführbaren Anweisungen Anweisungen zum Ausführen des Verfahrens nach einem der Ansprüche 1 bis 3 umfassen.

**Revendications**

1. Procédé (800) de décodage d'une image dans un décodeur vidéo ou d'image à partir d'un train binaire, le train binaire ayant des informations d'en-tête pour un ensemble de blocs, le décodeur ayant un décodeur arithmétique pour convertir le train binaire en cases, le décodeur comprenant un binariseur par défaut pour binarisation inverse pour reconstruire des symboles, le procédé (800) comprenant de :

obtenir (802) les informations d'en-tête à partir du train binaire ;

déterminer (804) à partir des informations d'en-tête qu'un binariseur modifié doit être utilisé, au lieu du binariseur par défaut, par rapport à une séquence de cases pour l'ensemble de blocs, et en réponse sélectionner le binariseur modifié pour la séquence de cases ;

décoder arithmétiquement le train binaire dans la séquence de cases; et

reconstruire (806) une séquence de symboles à partir de la séquence de cases en utilisant le binariseur sélectionné pour binariser inversement la séquence de cases

dans laquelle le binariseur par défaut comprend une première arborescence de codage pour la binarisation inverse, le binariseur modifié comprend une deuxième arborescence de codage pour la une binarisation inverse ayant une structure arborescente différente de nœuds internes et feuilles de la première arborescence de codage; un symbole représenté par un chemin dans une arborescence de codage constituée de branches depuis les nœuds internes en partant du nœud racine de l'arborescence de codage jusqu'à un nœud feuille respectif; les première et deuxième arborescences de codage comprenant des probabilités de nœuds internes associées aux branches des nœuds internes de l'arborescence de codage respective ; les probabilités de nœuds internes du binariseur sélectionné sont utilisées par le décodeur arithmétique pour le décodage arithmétique ;

dans lequel les informations d'en-tête comprennent des informations spécifiant la structure du deuxième arborescence de codage et une allocation de symboles aux nœuds feuilles de la deuxième arborescence de codage;

dans lequel les premier et second arbres de codage sont utilisés pour décoder des jetons; dans lequel un jeton est une chaîne binaire qui indique l'amplitude d'un coefficient de domaine de transformation quantifié ; et dans lequel la deuxième arborescence de codage est déterminée à satisfaire pour tout $i \neq j$ :

si le nombre de fois que le jeton i apparaît dans l'ensemble de blocs $f_i$ est supérieur au nombre de fois que le jeton j apparaît dans l'ensemble de blocs $f_j$,

alors le nombre de cases utilisées pour représenter le jeton i en utilisant la deuxième arborescence de codage $l_i$ est inférieur ou égal au nombre de cases utilisées pour représenter le jeton j en utilisant la deuxième arborescence de codage $l_j$ ;

le procédé (800) comprenant en outre de:
générer la deuxième arborescence de codage sur la base des informations d'en-tête.

2. Procédé (800) selon la revendication 1, dans lequel la détermination (804) que le binariseur modifié doit être utilisé est indépendante des contextes déterminés pour la séquence de symboles.

3. Procédé (800) selon une quelconque des revendications précédentes, comprenant en outre la détermination du contexte sur la base d'un modèle de contexte, et dans lequel la détermination à partir des informations d'en-tête que le binariseur modifié doit être utilisé est en outre basée, mais pas uniquement, sur le contexte déterminé.

4. Décodeur (1000) pour décoder une image à partir d'un flux binaire, le flux binaire ayant des informations d'en-tête pour un ensemble de blocs, le décodeur (1000) comprenant :

un processeur (1002) ;
une mémoire (1004) ;
un décodeur arithmétique adapté pour convertir le flux binaire en cases ;
un binariseur par défaut adapté pour binariser inversement des bacs pour reconstruire des symboles ;
un sélecteur de binariseur adapté pour déterminer à partir des informations d'en-tête qu'un binariseur doit être utilisé, à la place du binariseur par défaut, par rapport à une séquence de cases, et en réponse sélectionner le binariseur modifié pour la séquence de cases et
le binariseur sélectionné adapté pour reconstruire une séquence de symboles à partir de la séquence de cases de manière à binariser inversement la séquence de cases,
dans lequel le binariseur par défaut comprend une première arborescence de codage pour la binarisation inverse, le binariseur modifié comprend une deuxième arborescence de codage pour la binarisation inverse ayant une structure arborescente de nœuds internes et feuilles différente de la première arborescence de codage ; un symbole représenté par un chemin dans une arborescence de codage constitué de branches depuis les nœuds internes en partant du nœud racine de l'arborescence de codage jusqu'à un nœud feuille respectif ; la première et la deuxième arborescence de codage comprenant des probabilités de nœuds internes associées aux branches des nœuds internes de l'arborescence de codage respective ; les probabilités de nœuds internes du binariseur sélectionné sont utilisées par le décodeur arithmétique pour le décodage arithmétique ;
dans lequel les informations d'en-tête comprennent des informations spécifiant la structure de la deuxième arborescence de codage et une allocation de symboles aux nœuds feuilles de la deuxième arborescence de codage;
dans lequel la première et la deuxième arborescence de codage sont utilisées pour décoder des jetons; dans lequel un jeton est une chaîne binaire qui indique l'amplitude d'un coefficient de domaine de transformation quantifié; et dans lequel le deuxième arborescence de codage est déterminé à satisfaire pour tout $i \neq j$ : si le nombre de fois que ce jeton i apparaît dans l'ensemble de blocs $f_i$ est supérieur au nombre de fois que ce jeton j apparaît dans l'ensemble de blocs $f_j$, alors le nombre de cases utilisées pour représenter le jeton i en utilisant la deuxième arborescence de codage $l_i$ est inférieur ou égal au nombre de cases utilisées pour représenter le jeton j en utilisant la deuxième arborescence de codage $l_j$, et

dans lequel le décodeur (1000) est adapté pour générer la deuxième arborescence de codage sur la base des informations d'en-tête.

5. Décodeur (1000) selon la revendication 4, dans lequel le décodeur (1000) comprend un déterminateur de contexte, et le sélecteur de binariseur détermine que le binariseur modifié doit être utilisé indépendamment des contextes déterminés par le déterminateur de contexte pour la séquence de symboles.

6. Décodeur (1000) selon la revendication 4, comprenant en outre un déterminateur de contexte pour déterminer le contexte sur la base d'un modèle de contexte, et dans lequel la détermination par le sélecteur de binariseur que le binariseur modifié doit être utilisé est en outre basé, mais pas uniquement, sur le contexte déterminé.

7. Procédé (700) de codage d'une image dans un codeur d'image ou vidéo pour générer un train de bits de données encodées, l'image ayant un ensemble de blocs, le codeur ayant un codeur pour convertir des cases en train binaire de données codées, le codeur comprenant un binariseur par défaut pour binariser des symboles en cases, le procédé (700) comprenant de:

déterminer (702), pour l'ensemble de blocs, qu'un binariseur modifié doit être utilisé, au lieu du binariseur par défaut, pour binariser une séquence de symboles dans cet ensemble de blocs, et en réponse sélectionner le binariseur modifié pour la séquence de symboles, la détermination étant basée sur une fréquence d'occurrence respective pour chaque symbole dans l'ensemble de blocs et sur la base de l'attente que le binariseur modifié se traduira par une séquence binaire plus courte que ce qui serait autrement le cas avec le binariseur par défaut ;
binariser (704) la séquence de symboles en utilisant le binariseur sélectionné pour générer une séquence de cases;
coder arithmétiquement (706) la séquence de cases en utilisant le codeur arithmétique pour générer le train binaire de données codées; et
insérer (708) des informations d'en-tête dans le flux binaire qui indiquent que le binariseur modifié doit être utilisé, au lieu du binariseur par défaut, par rapport à la séquence de cases,
dans lequel le binariseur par défaut comprend une première arborescence de codage pour la binarisation, le binariseur modifié comprend une deuxième arborescence de codage pour la binarisation ayant une structure arborescente de nœuds internes et feuilles différente de la première arborescence de codage ; un symbole représenté par un chemin dans une arborescence de codage constituée de branches depuis les nœuds internes en partant du nœud racine de l'arborescence de codage jusqu'à un nœud feuille respectif ; la première et deuxième arborescence de codage comprenant des probabilités de nœuds associées aux branches des nœuds internes de l'arborescence de codage respectif ;
les probabilités de nœud interne du binariseur sélectionné sont utilisées par le codeur arithmétique pour le codage arithmétique ;
dans lequel les informations d'en-tête comprennent des informations spécifiant la structure de la deuxième arborescence de codage et une allocation de symboles aux nœuds feuilles de la deuxième arborescence de codage;
dans lequel la première et deuxième arborescence de codage sont utilisées pour coder des jetons; dans lequel un jeton est une chaîne binaire qui indique l'amplitude d'un coefficient de domaine de transformation quantifié ;
dans lequel la deuxième arborescence de codage est déterminée sur la base des probabilités de symboles respectives et en déterminant les probabilités de nœud interne pour la deuxième arborescence de codage ; et
dans lequel le deuxième arborescence de codage est déterminée à satisfaire pour tout $i \neq j$ : si le nombre de fois que ce jeton i apparaît dans l'ensemble de blocs $f_i$ est supérieur au nombre de fois que ce jeton j apparaît dans l'ensemble de blocs $f_j$, alors le nombre de cases utilisées pour représenter le jeton i en utilisant la deuxième arborescence de codage $l_i$ est inférieur ou égal au nombre de cases utilisées pour représenter le jeton j en utilisant le deuxième arborescence de codage $l_j$.

8. Support non transitoire lisible par un processeur mémorisant des instructions exécutables par processeur pour décoder une image dans une vidéo ou un décodeur d'image à partir d'un train binaire, le train binaire ayant des informations d'en-tête pour un ensemble de blocs, le décodeur ayant un décodeur arithmétique pour convertir le train binaire en cases, le décodeur comprenant un binariseur par défaut pour la binarisation inverse des cases en symboles de reconstruction, dans lequel les instructions exécutables par le processeur comprennent des instructions pour exécuter le procédé d'une quelconque des revendications 1 à 3.

**FIG. 1A**

**FIG. 1B**

50

Context
generator

$c_j$

Probability
generator

56

54

58

$b_{j-1}$

Delay

Data sequence

Inverse
binarizer

$b_j$

BAC decoder

Bitstream

52

**FIG. 2A**

150

Selection information

160

Binarizer
selector

Context
generator

$c_j$

Probability
generator

156

Delay

154

$b_{j-1}$

Delay

Inverse
binarizer

$b_j$

BAC decoder

$p_j$

Bitstream

Data
sequence

152

158

**FIG. 2B**

**FIG. 3A**

**FIG. 3B**

70

76

Context
generator

$C_j$

Probability
generator

78

$x_{i-1}$

Delay

74

$\vec{p_j}$

Data sequence

$x_i$

Inverse Binarizer

Bitstream

MAC decoder

72

**FIG. 4A**

170

Context
generator

$C_j$

Probability
generator

$x_{i-1}$

Delay

Binarizer
selector

$\vec{p_j}$

Selection information

$x_i$

Inverse Binarizer

Bitstream

Data
sequence

MAC decoder

**FIG. 4B**

**FIG. 5**

**FIG. 6**

702 — Determine that a modified binarizer is to be used for a sequence of symbols in a set of blocks

700

704 — Binarize the symbols using the modified binarizer to produce a sequence of bins

706 — Arithmetically encode the bins to generate the bitstream of encoded data

708 — Insert header information indicating that the modified binarizer is to be used to inverse binarize the bins corresponding to the sequence of symbols

## FIG. 7

802 — Extract header information from the bitstream

800

804 — Determine from the header information that a modified binarizer is to be used for a sequence of bins

806 — Reconstruct a sequence of symbols by inverse binarizing the sequence of bins using the modified binarizer instead of the default binarizer

**FIG. 8**

900

904

Encoder

Processor

902

Memory

906

Encoding Application

Communications
System

**FIG. 9**

1000

1004

Decoder

Processor

1002

Memory

Decoding Application

1006

Communications
System

**FIG. 10**

**EP 3 182 705 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2557792 A1